## Europäisches Patentamt

## European Patent Office

## Office européen des brevets

(11) Veröffentlichungsnummer: **0 261 372**
**B1**

(12) **EUROPÄISCHE PATENTSCHRIFT**

(45) Veröffentlichungstag der Patentschrift:
14.11.90

(51) Int. Cl.⁵: **C25D 17/28**

(21) Anmeldenummer: 87111604.2

(22) Anmeldetag: 11.08.87

(54) Verfahren zum Führen von plattenförmigen Gegenständen, sowie dazugehörige Vorrichtung.

(30) Priorität: 24.09.86 DE 3632378

(43) Veröffentlichungstag der Anmeldung:
30.03.88 Patentblatt 88/13

(45) Bekanntmachung des Hinweises auf die Patenterteilung:
14.11.90 Patentblatt 90/46

(84) Benannte Vertragsstaaten:
BE CH DE ES FR GB IT LI LU NL SE

(56) Entgegenhaltungen:
US-A- 2 942 719

(73) Patentinhaber: SCHERING AKTIENGESELLSCHAFT
Berlin und Bergkamen,
Müllerstrasse 170/178 Postfach 65 03 11,
D-1000 Berlin 65(DE)

(72) Erfinder: Bläsing, Horst, Strünkweg 1,
D-1000 Berlin 13(DE)
Erfinder: Kosikowski, Thomas, Stulbenweg 4,
D-8500 Nürnberg(DE)
Erfinder: Mankut, Ludwig, Memelstrasse 5,
D-8503 Altdorf(DE)
Erfinder: Meyer, Walter, Klosterheider Weg 18,
D-1000 Berlin 28(DE)

ACTORUM AG

## Beschreibung

Die Erfindung betrifft zunächst ein Verfahren gemäß dem Oberbegriff des Anspruches 1. Dabei ist bevorzugt an das Führen von Leiterplatten für die Elektronik gedacht, die in Elektrolysebehältern mit Kupfer oder anderen Metallen oder Metallegierungen metallisiert werden sollen. Hierzu ist es aus der DE-OS 32 36 545 bekannt, die zum Elektroplattieren vorgesehenen ebenen Werkstücke in waagerechter (bezogen auf die Horizontale) Lage durch einen Behälter hindurchzuführen. Da nun die plattenförmigen Gegenstände während der Elektrolysebehandlung im Behälter sich im Elektrolysebad befinden müssen und dabei die vorgenannte waagerechte Lage einnehmen, ergibt sich hieraus das Problem, daß die Ein- und Austrittsöffnungen einerseits den Durchtritt der in ihrer Dicke meist unterschiedlichen plattenförmigen Gegenstände erlauben müssen. Andererseits muß aber der Spiegel der Elektrolyseflüssigkeit im Behälter höher sein als die Lage der Durchtrittsöffnungen für die plattenförmigen Gegenstände. da andernfalls die Galvanisierung der plattenförmigen Gegenstände nicht erfolgen könnte. Hieraus ergibt sich aber das Problem, daß die vorgenannten Durchtrittsöffnungen gegen den Austritt von Elektrolyseflüssigkeit abgedichtet werden müssen, oder daß man im Falle des Austrittes von Elektrolyseflüssigkeit dafür sorgen muß, daß dies nicht zu schnell geschieht und daß vor allem die ausgetretene Flüssigkeit wieder in das Bad zurückgeführt wird. Die hiermit verbundenen Aufwendungen sind nicht unerheblich. Sie werden aber bei der vorbekannten Anordnung inkauf genommen, da nämlich der waagerechte Antransport und Abtransport der plattenförmigen Gegenstände zum o.g. Behälter hin, bzw. von diesem weg innerhalb einer größeren Anlage dann wichtig ist, wenn die plattenförmigen Gegenstände vor und/oder nach der Elektrolyse in waagerechter Lage anderweitig behandelt werden sollen.

Die Aufgabe der Erfindung besteht demgegenüber darin, ein Verfahren gemäß dem Oberbegriff des Anspruches 1 dahingehend zu verbessern, daß zwar der An- und Abtransport der plattenförmigen Gegenstände zum und vom Elektrolysebehälter in waagerechter Lage erfolgen kann, andererseits aber ohne ins Gewicht fallenden Mehraufwand das Problem des Austrittes von Elektrolyseflüssigkeit aus Behältereintritts- und Austrittsöffnungen für die plattenförmigen Gegenstände vermieden ist.

Die Lösung dieser Aufgabe wird zunächst, ausgehend vom Oberbegriff des Anspruches 1, in den Merkmalen des Kennzeichens des Anspruches 1 gesehen. In der gekippten Lage tauchen sie in ein Elektrolysebad ein, dessen Spiegel sich unterhalb des Niveaus, auf dem die plattenförmigen Gegenstände in horizontaler Lage transportiert werden, befinden, wobei aber ohne weiteres dafür gesorgt sein kann, daß der mit der Metallisierung zu versehende Teil der plattenförmigen Gegenstände sich innerhalb der Elektrolyseflüssigkeit, d.h. unterhalb des Flüssigkeitsspiegels befindet.

Eine bevorzugte Vorrichtung zur Durchführung des Verfahrens ist Gegenstand des Anspruches 2.

Man kann die Kippmittel, die erforderlichenfalls auch gegen andere Kippmittel auswechselbar sein können, so lang machen, daß der jeweilige plattenförmige Gegenstand zumindest soweit unter den Spiegel der Elektrolyseflüssigkeit getaucht wird, daß alle seine zu galvanisierenden Bereiche sich innerhalb dieser Flüssigkeit befinden, wobei aber der Flüssigkeitsspiegel tiefer als das o.g. Niveau liegt. Das Kippen um eine waagerechte und in Transportrichtung verlaufende Achse ist konstruktiv relativ einfach, erleichtert die Unterbringung von Anoden und erlaubt außerdem ihre Ausgestaltung in einer weiteren bevorzugten Ausführungsform der Erfindung gemäß Gegenstand des Anspruches 3, indem die Kippmittel zugleich als Transportmittel dienen bzw. an diesen angebracht sind.

Die Merkmale des Anspruches 4 ermöglichen die A nordnung eines solchen Behälters im Verlauf einer Gesamtanlage, die ein waagerechtes Antransportieren und außerdem waagerechtes Abtransportieren der plattenförmigen Gegenstände zum bzw. vom Behälter erfordert.

Die Merkmale des Anspruches 5 erlauben eine Schräglage und zugleich in dieser Lage eine Führung der plattenförmigen Gegenstände. Diese Schräglage empfiehlt sich dann, wenn der in der Vertikalen zur Verfügung stehende Raum für das Unterbringen der plattenförmigen Gegenstände im Bad relativ knapp ist. Aufgrund ihrer Schräglage können die plattenförmigen Gegenstände mit ihrem Gewicht auf einer Führungsschiene oder dergleichen aufliegen und darauf gleiten. Damit wird zum einen ihr Gewicht teilweise von dieser Führungsschiene oder dergleichen aufgenommen. Außerdem bildet diese Anordnung zugleich eine Sicherung gegen ein etwaiges Pendeln der plattenförmigen Gegenstände (bei senkrechter Aufhängung der plattenförmigen Gegenstände im Badbereich müßte eine solche Sicherung, falls notwendig, vorgesehen werden).

Weitere Vorteile und Merkmale der Erfindung sind der nachstehenden Beschreibung und der zugehörigen Zeichnung von erfindungsgemäßen Ausführungsbeispielen zu entnehmen. In den schematischen Zeichnungen zeigt:

Fig. 1: ein erstes Ausführungsbeispiel der Erfindung in der Seitenansicht,
Fig. 2: die zu Fig. 1 gehörende Draufsicht,
Fig. 3: einen Schnitt gemäß der Linie III-III in Fig. 2,
Fig. 4: ein weiteres Ausführungsbeispiel in einem Querschnitt.

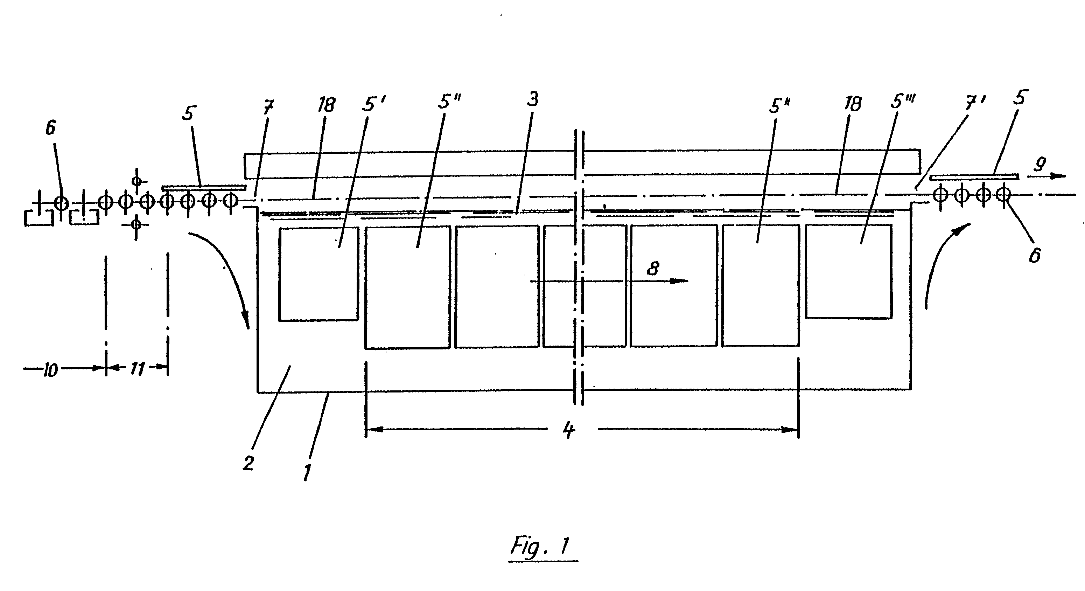

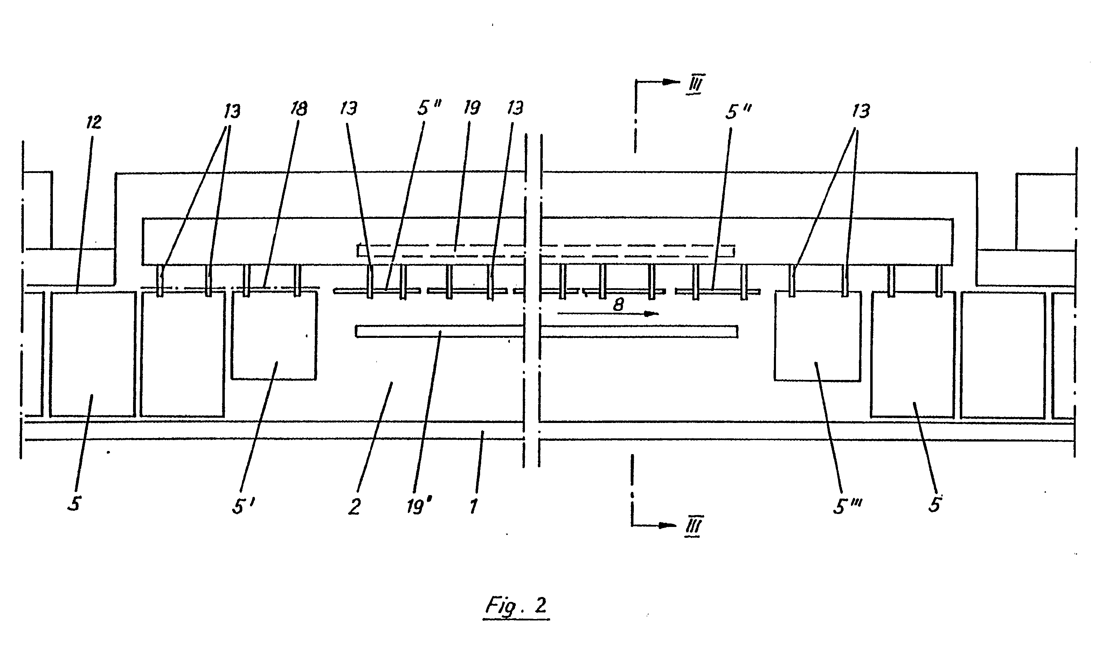

Die Fig. 1, 2 zeigen einen Behälter 1 mit einem Elektrolysebad 2 und nicht gesondert dargestellten Stromzuführungs- und Stromableitungsmitteln. Der Elektrolyse- oder Anodenbereich (auch Badbereich genannt) ist mit 4 beziffert.

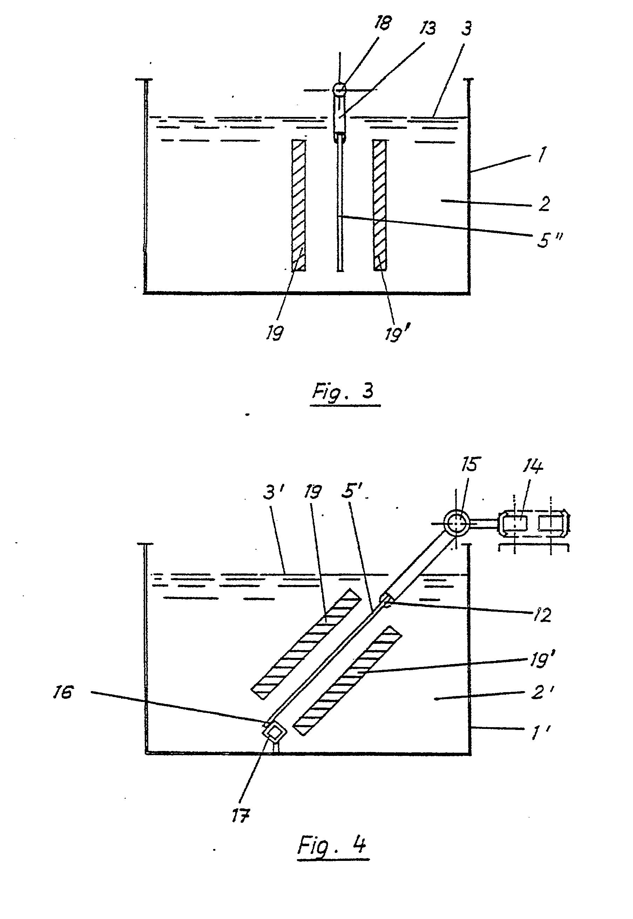

Die galvanisch zu metallisierenden plattenförmigen Gegenstände, bevorzugt für die Elektronik vorgesehene Leiterplatten 5, werden in den Zeichnungen von links her über Transportmittel, wie Rollen 6, in waagerechter Lage herangeführt und treten durch eine waagerecht verlaufende, schlitzförmige Öffnung 7 in den Behälter 1 ein. Nach ihrem Eintritt werden sie um eine waagerechte und in der Transportrichtung 8 bzw. 9 verlaufende Achse 18 (siehe strichpunktierte Linien in den Fig. 1 und 2) abgekippt und gelangen über eine bereits schräge Zwischenstellung 5' in eine Endlage, hier eine senkrechte Position 5". In dieser senkrechten Position laufen sie in Pfeilrichtung 8 durch den Anodenbereich durch, um nach Verlassen des Anodenbereiches über eine der Position 5' entsprechende Zwischenlage 5"' ebenfalls um die waagerechte und in Transportrichtung verlaufende Achse 18 wieder in die waagerechte Lage gekippt, um schließlich über einen Austrittsschlitz 7' in dieser waagerechten Lage 5 den Behälter 1 in Pfeilrichtung 9 zu verlassen. Wie Fig. 3 zeigt, kann in der senkrechten Position 5" der plattenförmigen Gegenstände der Platz beiderseits dieser Gegenstände zur Unterbringung von Anoden 19 ausgenutzt werden, ohne daß hierzu die Abmessungen des Behälters 1 vergrößert werden müßten.

Es ist ferner ersichtlich, daß somit in der Metallisierungsphase (Anodenbereich 4) sich die plattenförmigen Gegenstände 5" unterhalb des Flüssigkeitsspiegels 3 des Elektrolysebades 2 befinden, wobei aber dieser Spiegel 3 sich unterhalb der Ein- und Ausführungsöffnungen 7, 7' für die in waagerechter Position bewegten plattenförmigen Gegenstände 5 befindet.

Während die plattenförmigen Gegenstände durch die genannten Rollen 6 oder andere Transportmittel von vorhergehenden bzw. zu nachfolgenden Bearbeitungsbereichen, wie einer chemischen Behandlung 10 und einem Spülbereich 11, an den Behälter 1 herangeführt bzw. von ihm weg transportiert werden, sind im Behälter Mittel, z.B. schematisch angedeutete Zangen 13 vorgesehen, welche die plattenförmigen Gegenstände an einem Seitenrand 12 erfassen und zugleich dem Transport in der Pfeilrichtung 8 dienen können. Entweder an den freien Enden dieser Haltemittel 13 oder auch an ihren Anbringungen am Behälter sind die die Achse 18 bildenden, im Detail nicht gesondert dargestellten Kippvorrichtungen vorgesehen, welche die plattenförmigen Gegenstände aus der waagerechten Position 5 in die Zwischenlage 5' bzw. senkrechte Lage 5" kippen bzw. aus der senkrechten Lage 5" über die Zwischenlage 5"' in die Endlage 5 an der in Fig. 1, 2 rechts dargestellten Seite bringen. Solche Kippvorrichtungen müssen zumindest im Eingangs- und Ausgangsbereich des Behälters 1 vorgesehen sein, während vom Prinzip her der Transport im Anodenbereich 4 auch von anderen Mitteln erfolgen könnte, die zweckmäßigerweise zugleich die Stromzuführung beinhalten. Es liegt aber auch im Bereich der Erfindung, das Kippen, den Transport und die Stromzuführung von zu einer Einheit zusammengefaßten Mitteln bzw. Vorrichtungen durchführen zu lassen.

Das Ausführungsbeispiel der Fig. 4 zeigt einen Querschnitt durch einen Behälter 1' mit Badflüssigkeit 2' und Badspiegel 3'. Die plattenförmigen Gegenstände nehmen im Anodenbereich eine Schräglage 5' ein und sind an Transportmitteln 14 befestigt, die eine Kippvorrichtung 15 aufweisen. Die Galvanisierung erfolgt in dieser Schräglage, wobei die unteren Enden 16 der plattenförmigen Gegenstände auf einer Führungsschiene 17 gleiten, die sich zumindest durch den Anodenbereich (siehe Ziffer 4 in Fig. 1) erstreckt. Auch hier sind die mit 19' bezifferten Anoden raumsparend beiderseits der in Schräglage befindlichen plattenförmigen Gegenstände 5' unterbringbar.

Alle dargestellten Merkmale und ihre Kombinationen untereinander sind erfindungswesentlich.

**Patentansprüche**

1. Verfahren zum Führen von plattenförmigen Gegenständen zwecks elektrolytischer Metallisierung in, durch und aus einem Behälter, der das Elektrolysebad und die zur Elektrolyse gehörenden Mittel aufweist, dadurch gekennzeichnet, daß die plattenförmigen Gegenstände (5) in einer waagerechten Lage antransportiert und in den Behälter (1) eingeführt und danach um eine waagerechte und in Transportrichtung verlaufende Achse (18) soweit in das Bad abgekippt werden, bis sie vollständig oder zumindest in dem zu galvanisierenden Bereich unterhalb des Badspiegels (3) liegen, anschließend durch den Elektrolysebereich (4) des Behälters hindurch transportiert, danach wieder in die waagerechte Lage (5) zurückgeschwenkt und schließlich aus dem Behälter (1) heraus bewegt werden.

2. Vorrichtung zur Durchführung des Verfahrens nach Anspruch 1, dadurch gekennzeichnet, daß zumindest in den beiden Kippbereichen zu Beginn und zu Ende des Behälters (1) Mittel (13, 14, 15) zum Erfassen einer Seite (12) der plattenförmigen Gegenstände und zu deren Kippen um eine waagerechte und in Transportrichtung verlaufende Achse (18) vorgesehen sind, wobei diese Kippmittel so lang ausgebildet sind, daß sich in der abgekippten Lage die plattenförmigen Gegenstände bis unter den Spiegel (3, 3') der Badflüssigkeit (2, 2') tauchen, der sich unterhalb der Eintritts- und Austrittsöffnungen (7, 7') für die plattenförmigen Gegenstände (5) befindet.

3. Vorrichtung nach Anspruch 2, dadurch gekennzeichnet, daß die Kippmittel zugleich dem Halt und Transport der plattenförmigen Gegenstände (5) durch den Behälter einschließlich dessen Elektrolysebereich bzw. Anodenbereich (4), dienen, bzw. daß die Kippmittel an entsprechenden Transportmitteln des Behälters angebracht sind.

4. Vorrichtung nach Anspruch 2 oder 3, dadurch gekennzeichnet, daß gesonderte Vorrichtungen (6) zum Transport der plattenförmigen Gegenstände (5) zu bzw. vom Behälter (1) und dem Einführen bzw. Herausführen in den bzw. aus dem Behälter vorgesehen sind.

5. Vorrichtung nach einem der Ansprüche 2 bis 4, dadurch gekennzeichnet, daß für den Halt und die Führung des plattenförmigen Gegenstände (5') in einer Schräglage (Fig. 3) zur Horizontalen eine Führungsschiene oder dergleichen (17) vorgesehen ist, auf der das untere Ende (16) des jeweiligen plattenförmigen Gegenstandes in dessen Schräglage gleitet, während die Transport- und Kippvorrichtung (14, 15) an dem jeweils oberen Ende (12) des plattenförmigen Gegenstandes angreift.

6. Vorrichtung nach einem der Ansprüche 2 bis 5, dadurch gekennzeichnet, daß die Anoden (19, 19') beidseitig der Bewegungsbahn der in senkrechter Lage oder Schräglage durch den Elektrolysebereich (4) sich erstreckenden Bewegungsbahn der plattenförmigen Gegenstände befinden.

## Revendications

1. Procédé de guidage vers, à travers et à partir d'un bac d'objets plats en vue de leur métallisation électrolytique, ce bac contenant le bain électrolytique et les agents d'électrolyse, caractérisé par ce que les objets plats (5) sont amenés et introduits dans le bac (1) en position horizontale, puis basculés dans le bain autour d'un axe (18) parallèle au sens de déplacement jusqu'à ce qu'ils se trouvent complètement immergés ou au moins que leurs parties à galvaniser soient situées au-dessous du niveau (3) du bain, puis transportés à travers la zone (4) d'électrolyse du bac, puis ramenés en position horizontale (5) et, finalement, sortis du bac (1).

2. Dispositif permettant la réalisation du procédé suivant la revendication 1, caractérisé par ce qu'au moins dans les deux zones de basculement à l'entrée et à la sortie du bac sont installés (1) des organes (13, 14, 15) permettant de saisir le bord (12) des objets plats et de les faire basculer autour d'un axe (18) horizontal et parallèle au sens de déplacement, ces organes étant d'une longueur telle qu'en position basculée ils immergent les objets plats au-dessous de la surface (3, 3') du liquide du bain (2, 2') située au-dessous des ouvertures d'introduction et de sortie (7, 7') des objets plats (5).

3. Dispositif suivant la revendication 2, caractérisé par ce que les organes de basculement servent également à maintenir les objets plats (5) et à les transporter à travers le bac et sa zone d'électrolyse ou anodique (4), ou par ce que les organes de basculement sont fixés à des organes de transport analogues solidaires du bac.

4. Dispositif suivant la revendication 2 ou 3, caractérisé par ce que des dispositifs (6) distincts sont prévus pour amener les objets plats (5) vers le bac (1) et les évacuer du bac ainsi que pour les introduire dans le bac et les en ressortir.

5. Dispositif suivant l'une des revendications 2 à 4, caractérisé par ce qu'un rail de guidage (17) ou un élément analogue est prévu pour soutenir et guider les objets plats (5') en position inclinée (figure 3) sur l'horizontale, l'extrémité inférieure (16) de chaque objet plat glissant, dans sa position inclinée, sur ce rail ou élément analogue pendant que le dispositif de transport et de basculement (14, 15) saisit l'extrémité supérieure (12) de l'objet plat concerné.

6. Dispositif suivant l'une des revendications 2 à 5, caractérisé par ce que les anodes (19, 19') sont disposées des deux côtés de la trajectoire des objets plats parcourant en position verticale ou inclinée la zone d'électrolyse (4).

## Claims

1. Process for the guidance of board-shaped objects for electrolytic metal plating in, through and from a tank containing the electrolytic bath and the agent belonging to the electrolysis, characterized in that the board-shaped objects (5) are transported to the tank in a horizontal position and introduced into the tank (1) and then tilted into the bath around a horizontal axis (18) in the direction of transport until they are completely, or at least in the area to be electroplated, beneath the level of the bath (3), subsequently transported through the electrolytic area (4) of the tank, then swiveled back to the horizontal position (5) again and finally moved out of the tank (1).

2. Device for implementation of the process set out in Claim 1, characterized in that at least in the two tilting areas at the beginning and end of the tank (1) implements (13, 14, 15) are provided for the gripping of one side (12) of the board-shaped objects and for tilting the same around a horizontal axis (18) running in the direction of transport, these tilting implements being of such a length that in the tilted position they immerse the board-shaped objects under the level (3, 3') of the bath liquid (2, 2'), which is beneath the inlet and outlet openings (7, 7') for the board-shaped objects (5).

3. Device in accordance with Claim 2, characterized in that the tilting implements simultaneously serve to hold and transport the board-shaped objects (5) through the tank, including its electrolysis area or anode area (4), or in that the tilting implements are attached to corresponding means of transport of the tank.

4. Device in accordance with Claim 2 or 3, characterized in that separate devices (6) are provided for transport of the board-shaped objects (5) to or from the tank (1) and for introduction into or withdrawal from the tank.

5. Device in accordance with one of Claims 2 to 4, characterized in that for the holding and guidance of the board-shaped objects (5') at an inclined angle (Fig. 3) to the horizontal there is a guide rail or the like (17) on which the bottom end (16) of the respective board-shaped object slides in its inclined position, while the transport and tilting device (14, 15) grips the respective top end (12) of the board-shaped object.

6. Device in accordance with one of Claims 2 to 5, characterized in that the anodes (19, 19') are located on both sides of the trajectory of the board-shaped objects extending in a perpendicular or inclined position through the electrolysis area (4).

Fig. 1

EP 0 261 372 B1

Fig. 2

Fig. 3

Fig. 4